Europäisches Patentamt

European Patent Office

Office européen des brevets

(19)

(11) EP 0 706 662 B1

(12) EUROPÄISCHE PATENTSCHRIFT

(45) Veröffentlichungstag und Bekanntmachung des
Hinweises auf die Patenterteilung:
04.06.1997 Patentblatt 1997/23

(21) Anmeldenummer: 94908961.9

(22) Anmeldetag: 10.03.1994

(51) Int Cl.6: G01R 15/24

(86) Internationale Anmeldenummer:
PCT/DE94/00252

(87) Internationale Veröffentlichungsnummer:
WO 94/24573 (27.10.1994 Gazette 1994/24)

(54) **OPTISCHES MESSVERFAHREN ZUM MESSEN EINES ELEKTRISCHEN WECHSELSTROMES MIT TEMPERATURKOMPENSATION UND VORRICHTUNG ZUR DURCHFÜHRUNG DES VERFAHRENS**

OPTICAL METHOD OF MEASURING AN ALTERNATING ELECTRICAL CURRENT, INCLUDING TEMPERATURE COMPENSATION, AND A DEVICE FOR CARRYING OUT THE METHOD

PROCEDE OPTIQUE PERMETTANT DE MESURER UN COURANT ALTERNATIF ELECTRIQUE COMPENSE EN TEMPERATURE ET DISPOSITIF DE MISE EN OEUVRE DU DIT PROCEDE

(84) Benannte Vertragsstaaten:
AT BE CH DE FR GB IT LI SE

(30) Priorität: 14.04.1993 DE 4312183

(43) Veröffentlichungstag der Anmeldung:
17.04.1996 Patentblatt 1996/16

(73) Patentinhaber: SIEMENS
AKTIENGESELLSCHAFT
80333 München (DE)

(72) Erfinder: BOSSELMANN, Thomas
D-91054 Erlangen (DE)

(56) Entgegenhaltungen:
EP-A- 0 088 419          EP-A- 0 557 090
WO-A-91/01501          US-A- 4 755 665
US-A- 4 973 899

**Beschreibung**

Die Erfindung betrifft ein Verfahren zum Messen eines elektrischen Wechselstromes in einem Stromleiter gemäß dem Oberbegriff des Anspruchs 1 und eine Vorrichtung zum Messen eines elektrischen Wechselstromes in einem Stromleiter gemäß dem Oberbegriff des Anspruchs 10. Ein solches Verfahren und eine solche Vorrichtung sind beispielsweise aus US 4 755 665 oder US-A-4 973 899 bekannt.

Es sind optische Meßvorrichtungen zum Messen eines elektrischen Stromes in einem Stromleiter unter Ausnutzung des Faraday-Effekts bekannt, die auch als magnetooptische Stromwandler bezeichnet werden. Unter dem Faraday-Effekt versteht man die Drehung der Polarisationsebene von linear polarisiertem Licht in Abhängigkeit von einem Magnetfeld. Der Drehwinkel ist dabei proportional zum Wegintegral über dem magnetischen Feld entlang des von dem Licht zurückgelegten Weges mit der Verdet-Konstanten als Proporitonalitätskonstanten. Die Verdet-Konstante ist abhängig von dem Material, in dem das Licht verläuft, von dessen Temperatur und von der Wellenlänge des Lichts. Zum Messen des Stromes ist ein Faraday-Element in der Nähe des Stromleiters angeordnet, das aus einem optisch transparenten, den Faraday-Effekt zeigenden Material und im allgemeinen aus Glas besteht.

Durch das Faraday-Element wird von einer Sendeeinheit linear polarisiertes Licht geschickt. Das von dem elektrischen Strom erzeugte Magnetfeld bewirkt eine Drehung der Polarisationsebene des Lichtes in dem Faraday-Element um einen Polarisationsdrehwinkel, die von einer Auswerteeinheit als Maß für die Stärke des Magnetfeldes und damit für die Stärke des elektrischen Stromes ausgewertet werden kann. Im allgemeinen umgibt das Faraday-Element den Stromleiter, so daß das polarisierte Licht den Stromleiter in einem quasi geschlossenen Weg umläuft. Dadurch ist der Betrag des Polarisationsdrehwinkels in guter Näherung direkt proportional zur Amplitude des Meßstromes.

In einer bekannten Ausführungsform ist das Faraday-Element als massiver Glasring um den Stromleiter ausgebildet. Das Licht umläuft den Stromleiter in dieser Ausführungsform einmal (EP-B1-0 088 419).

In einer anderen bekannten Ausführungsform ist das Faraday-Element als Teil einer optischen Monomode-Faser ausgebildet, die den Stromleiter in Form einer Meßwicklung umgibt. Das Licht umläuft den Stromleiter daher bei einem Durchlauf N-mal, wenn $N \geq 1$ die Anzahl der Windungen der Meßwicklung ist. Es sind zwei Typen von solchen magnetooptischen Stromwandlern mit einer Meßwicklung einer Lichtfaser bekannt, nämlich der Transmissionstyp und der Reflexionstyp. Beim Transmissionstyp wird das Licht in ein Ende der Faser eingekoppelt und am anderen Ende wieder ausgekoppelt, so daß das Licht die Meßwicklung nur einmal durchläuft. Beim Reflexionstyp ist dagegen das andere Ende der Faser verspiegelt, so daß das an dem ersten Ende angekoppelte Licht an diesem anderen, verspiegelten Ende reflektiert wird, die Meßwicklung ein zweites Mal in umgekehrter Richtung durchläuft und am ersten Ende wieder ausgekoppelt wird. Wegen der Nicht-Reziprozität des Faraday-Effekts wird die Polarisationsebene des Lichts beim umgekehrten Durchlauf nochmal um den gleichen Betrag in die gleiche Richtung gedreht. Der Drehwinkel ist somit bei gleicher Meßwicklung doppelt so groß wie beim Transmissionstyp. Zur Trennung des eingekoppelten und des ausgekoppelten Lichts ist ein Strahlteiler vorgesehen (WO 91/01501).

Es sind ferner Verfahren zum Auswerten der Information, die in der gedrehten Polarisationsebene des Meßlichts über den Meßstrom enthalten ist, und entsprechende Vorrichtungen zur Durchführung dieser Verfahren bekannt, bei denen prinzipiell alle bekannten Ausführungsformen von Faraday-Elementen vorgesehen sein können.

Ein Problem bei allen magnetooptischen Stromwandlern sind Störeinflüsse durch lineare Doppelbrechung in dem Faraday-Element und den optischen Übertragungsstrecken. Solche lineare Doppelbrechung kann durch mechanische Spannungen in dem Material, die beispielsweise durch Verbiegen oder Vibration und insbesondere durch Temperaturänderungen hervorgerufen werden können, verursacht werden.

Bei dem bereits genannten, aus der EP-B1-0 088 419 bekannten magnetooptischen Stromwandler wird mit einem Polarisator das Licht einer Lichtquelle linear polarisiert und dann in das Faraday-Element eingekoppelt. Das linear polarisierte Licht durchläuft das Faraday-Element und wird wieder ausgekoppelt. Das ausgekoppelte Licht wird mit einem Wollaston-Prisma als strahlteilendem Analysator in zwei linear polarisierte Lichtsignale A und B mit senkrecht zueinander gerichteten Polarisationsebenen geteilt. Diese beiden Lichtsignale A und B werden über entsprechende optische Übertragungsfasern zu entsprechenden Lichtdetektoren übertragen und in entsprechende elektrische Signale PA und PB umgewandelt. Aus diesen beiden Signalen PA und PB wird in einer Recheneinheit ein Faraday-Drehwinkel als Meßsignal berechnet, der dem Quotienten (PA-PB/PA+PB) aus der Differenz und der Summe der beiden Signale entspricht. Durch diese Quotientenbildung werden unterschiedliche Empfindlichkeiten der Lichtdetektoren und unterschiedliche Dämpfungsfaktoren für die Intensitäten der Lichtsignale A und B in den beiden Übertragungsfasern ausgeglichen. Temperatureinflüsse können damit jedoch nicht kompensiert werden.

Bei einem anderen bekannten Auswerteverfahren werden die beiden Signale PA und PB jeweils in einem Filter in ihre Gleichstromanteile PA(DC) bzw. PB(DC) und ihre Wechselstromanteile PA(AC) bzw. PB(AC) unterteilt. Aus dem Wechselstromanteil PA(AC) bzw. PB(AC) und dem Gleichstromanteil PA(DC) bzw. PB(DC) wird für jedes Signal PA und PB zum Ausgleich von variierenden Lichtintensitäten infolge von Übertragungs- und Empfindlichkeitsschwankungen der Quotient QA = PA(AC)/PA(DC) bzw. QB = PB(AC)/PB(DC) aus seinem Wechselstrcmanteil PA(AC) bzw. PB(AC) und seinem Gleichstromanteil PA(DC) bzw. PA(DC) gebildet. Aus jedem dieser beiden Quotienten QA und QB wird ein zeitlicher Mittelwert $\overline{QA}$ und $\overline{QB}$ gebildet, und aus diesen beiden Mittelwerten $\overline{QA}$ und $\overline{QB}$ wird schließlich ein Quotient Q = $\overline{QA}/\overline{QB}$ gebildet (US 4,755,655). Im Rahmen eines aus Proc. Conf. Opt. Fiber Sensors OFS 1988, New Orleans, Seiten 288 bis 291 bekannten Iterationsverfahrens wird durch Vergleich mit in einer Wertetabelle (Look-up-table) gespeicherten, geeichten Werten ein Korrekturfaktor K für den ermittelten Quotienten Q erhalten. Der um diesen Korrekturfaktor K korrigierte Quotient QxK wird als temperaturkompensierter Meßwert für den Meßstrom herangezogen. Mit diesem Verfahren kann die Temperaturempfindlichkeit des magnetooptischen Stromwandlers auf etwa 1/50 herabgesetzt werden. Jedoch ist dieses Iterationsverfahren recht aufwendig.

Aus US-A-4,973,899 ist eine Meßvorrichtung mit einem Faraday-Element bekannt, bei der linear polarisiertes Meßlicht nach Durchlaufen des Faradayelements in zwei Lichtteilstrahlen zerlegt wird und diese beiden Lichtteilsignale von jeweils einem Photodetektor jeweils in ein elektrisches Intensitätssignal umgewandelt werden. Es sind Mittel zum Bilden des Quotienten aus einem Wechselsignalanteil und einem Gleichsignalanteil für jedes Intensitätssignal vorgesehen. Mit diesen beiden Quotienten werden ein erstes Ausgangssignal als Maß für einen Wechselstrom und ein zweites Ausgangssignal für einen Gleichstrom abgeleitet.

Der Erfindung liegt nun die Aufgabe zugrunde, ein Verfahren und eine Vorrichtung zum Messen eines elektrischen Wechselstromes in einem Stromleiter unter Ausnutzung des Faraday-Effekts anzugeben, bei denen Temperatureinflüsse auf das Meßsignal vermindert werden.

Diese Aufgabe wird gemäß der Erfindung gelöst mit den Merkmalen des Anspruchs 1 bzw. des Anspruchs 10. Die Erfindung geht aus von der durch Messungen gewonnenen Beobachtung, daß die beiden Meßkanäle für die beiden Lichtsignale in ihren Gleichsignalanteilen Temperaturkoeffizienten mit unterschiedlichen Vorzeichen und in ihren Wechselsignalanteilen Temperaturkoeffizienten mit gleichen, im allgemeinen positiven Vorzeichen aufweisen. Das bedeutet, daß der Gleichsignalanteil eines Signals mit steigender Temperatur zunimmt und der Gleichsignalanteil des anderen Signals abnimmt. Der Wechselsignalanteil nimmt dagegen bei beiden Signalen mit steigender Temperatur zu. Die Erfindung beruht nun auf der Überlegung, daß durch die Bildung eines Funktionswertes aus den beiden, gegebenenfalls auch normierten Signalen unter Ausnutzung der beobachteten unterschiedlichen Temperaturabhängigkeiten von Gleich- und Wechselsignalanteilen ein Maß für die Temperatur T erhalten und mit diesem Funktionswert die temperaturabhängige Arbeitspunktdrift des Faraday-Sensors korrigiert werden kann.

Vorteilhafte Ausgestaltungen des Verfahrens und der Vorrichtung gemäß der Erfindung ergeben sich aus den jeweils abhängigen Ansprüchen.

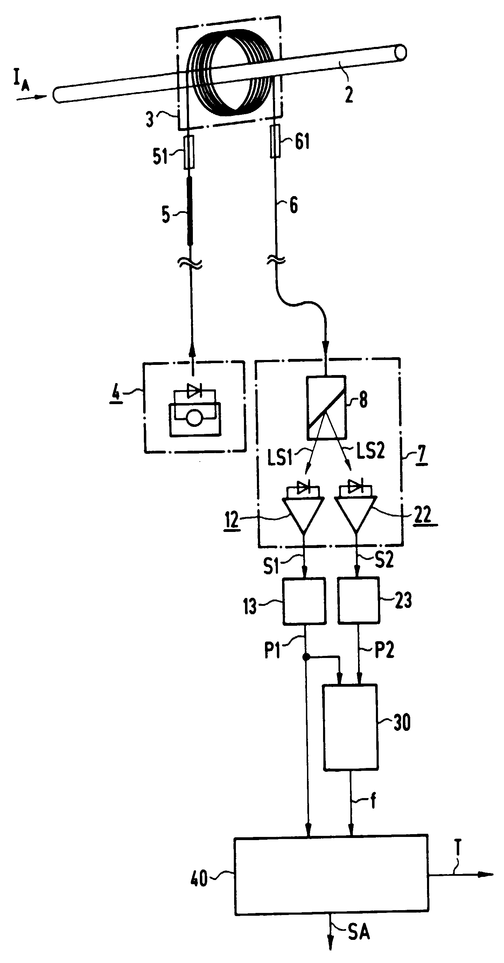

Zur weiteren Erläuterung der Erfindung wird auf die Zeichnung Bezug genommen, in deren einziger Figur ein Ausführungsbeispiel einer Vorrichtung schematisch dargestellt ist, mit der ein Verfahren zum Messen eines elektrischen Wechselstromes unter Ausnutzung des Faraday-Effekts gemäß der Erfindung durchgeführt werden kann.

Es sind ein Stromleiter mit 2, ein Faraday-Element mit 3 und eine Lichtquelle mit 4, ein Polarisator mit 5, ein Lichtwellenleiter mit 6, eine Wandlereinheit mit 7, zwei Filter- und Divisionseinheiten mit 13 und 23, eine Recheneinheit mit 30 sowie eine Auswerteeinheit mit 40 bezeichnet.

An einem Eingang des Faraday-Elements 3 wird in dem Polarisator 5 linear polarisiertes Licht der Lichtquelle 4 in das Faraday-Element 3 eingekoppelt. Statt Lichtquelle 4 und Polarisator 5 kann auch eine polarisierende Lichtquelle, beispielsweise eine Laserdiode, vorgesehen sein. An einem Ausgang des Faraday-Elements 3 wird das Licht wieder ausgekoppelt und über den polarisationserhaltenden Lichtwellenleiter 6, für den vorzugsweise eine Monomode-Lichtfaser vorgesehen ist, der Wandlereinheit 7 zugeführt. Dämpfungsverluste in dem Lichtwellenleiter 6 spielen wegen seiner polarisationserhaltenden Eigenschaft praktisch keine Rolle. Das ausgekoppelte Licht weist eine aufgrund des Faraday-Effekts um einen Meßwinkel ALPHA gedrehte Polarisation auf. Der Meßwinkel ALPHA ist dabei abhängig von dem Wechselstrom $I_A$ in dem Stromleiter 2. In der dargestellten Ausführungsform sind das Faraday-Element 3 selbst und die Übertragungsfaser zwischen Lichtquelle 4 und Faraday-Element 3 als Teile des Lichtwellenleiters 6 ausgebildet. Der Lichtwellenleiter 6 umgibt dabei vorzugsweise konzentrisch den Stromleiter 2 in einer Meßwicklung mit wenigstens einer Meßwindung. Neben der dargestellten Ausführungsform vom Transmissionstyp ergibt ist auch ein Stromwandler vom Reflexionstyp möglich. Außerdem kann als Faraday-Element 3 auch ein massiver Körper aus einem transparenten Material, vorzugsweise ein Glasring, vorgesehen sein. Dem Faraday-Element 3 können zwei Spleiße 51 und 61 als lösbare Verbindungen mit der Lichtquelle 4 bzw. der Wandlereinheit 7 zugeordnet sein. Die Wandlereinheit 7 kann auch direkt am Ausgang des Faraday-Elements 3 angeordnet sein, so daß der Lichtwellenleiter 6 zwischen Faraday-Element 3 und Wandlereinheit entfallen kann.

In der Wandlereinheit 7 wird das aus dem Faraday-Element 3 ausgekoppelte Licht in zwei linear polarisierte Lichtsignale LS1 und LS2 mit verschiedenen und vorzugsweise senkrecht zueinander gerichteten Polarisationsebenen aufgespalten. Dazu ist vorzugsweise ein Wollaston-Prisma als strahlteilender Analysator 8 vorgesehen. Es können als Analysator 8 allerdings auch zwei um einen entsprechenden Winkel und vorzugsweise um 90° gekreuzte Polarisationsfilter und ein Strahlteiler vorgesehen sein. Die beiden Lichtsignale LS1 und LS2 werden dann in zugeordneten optoelektrischen Wandlern 12 bzw. 22, für die vorzugsweise in Verstärkerkreise geschaltete Empfangs-LEDs vorgesehen sind, in elektrische Signale S1 bzw. S2 umgewandelt, die ein Maß für die Lichtintensitäten der jeweiligen Lichtsignale LS1 bzw. LS2 sind. An zwei Ausgängen der Wandlereinheit 7 stehen diese beiden elektrischen Signale S1 und S2 an.

Das Signal S1 wird in einer bevorzugten Ausführungsform der Filter- und Divisionseinheit 13 und das Signal S2 wird der Filter- und Divisionseinheit 23 zugeführt. In der ihm zugeordneten Filter- und Divisionseinheit 13 bzw. 23 wird jedes der beiden Signale S1 und S2 in seinen Gleichsignalanteil (DC-Signal) D1 bzw. D2 und seinen Wechselsignalanteil (AC-Signal) A1 bzw. A2 zerlegt, und es wird für jedes Signal S1 und S2 ein intensitätsnormiertes Signal P1 bzw. P2 als Quotient P1=A1/D1 bzw. P2=A2/D2 aus seinem Wechselsignalanteil A1 bzw. A2 und seinem Gleichsignalanteil D1 bzw. D2 gebildet. Durch die Intensitätsnormierung der Signale S1 und S2 können Intensitätsschwankungen in den für die entsprechenden Lichtsignale LS1 und LS2 vorgesehenen Übertragungsstrecken und Empfindlichkeitsunterschiede in diesen beiden Übertragungsstrecken ausgeglichen werden. Dies ist insbesonders dann von Vorteil, wenn diese Übertragungsstrecken relativ lang sind, beispielsweise wenn der Analysator 8 in der Nähe des Faraday-Elements 3 angeordnet ist. Die Lichtsignale LS1 und LS2 werden insbesondere in dieser Ausführungsform auch über Lichtwellenleiter als Übertragungsstrecken übertragen, die den strahlteilenden Analysator 8 und die optoelektrischen Wandler 12 bzw. 22 miteinander verbinden.

Eines der intensitätsnormierten Signale, beispielsweise P1, wird als noch nicht temperaturkompensiertes Meßsignal vorgesehen. Aus beiden normierten Signalen P1 und P2 wird nun in der Recheneinheit 30 ein Funktionswert f(P1, P2) gebildet, der gleich der Differenz P1-P2 (oder P2-P1) der beiden Signale P1 und P2 oder gleich dem Quotienten P1/P2 (oder P2/P1) der beiden Signale P1 und P2 sein kann. Sowohl die Differenz P1-P2 als auch der Quotient P1/P2 der beiden normierten Signale P1 und P2 enthalten eine eindeutige Information über die Temperatur T des optischen Systems. Das Meßsignal P1 und der Funktionswert f(P1, P2) werden nun der Auswerteeinheit 40 zugeführt. In dieser Auswerteeinheit 40 wird aus dem Funktionswert f(P1, P2) ein Temperaturmeßwert T ermittelt, der vorzugsweise an einem ihm zugeordneten Ausgang der Auswerteeinheit 40 abgegriffen werden kann. Mit diesem Temperaturmeßwert T wird aus dem normierten Signal P1 ein in seinem Arbeitspunkt korrigiertes Meßsignal SA für den Wechselstrom $I_A$ ermittelt, das nun weitgehend temperaturunabhängig ist und an einem Ausgang der Auswerteeinheit 40 ansteht.

Vorzugsweise ist in der Auswerteeinheit 40 eine vorab ermittelte Wertetabelle gespeichert, mit der dem Funktionswert f der entsprechende Temperaturmeßwert T zugeordnet wird. Mit diesem Temperaturmeßwert T wird dann die Korrektur des Arbeitspunktes des Meßsignals SA durchgeführt.

Der Temperaturmeßwert T kann allerdings auch durch Anpassung (Fitting) der Funktion f(P1, P2) an eine Vergleichsfunktion (Eichkurve) ermittelt werden. Als Vergleichsfunktion eignen sich insbesondere lineare oder quadratische Funktionen von P1 und P2 oder auch ein Quotient (aP1-bP2)/(cP1-dP2) aus zwei linearen Funktionen von P1 und P2 mit anzupassenden reellen Koeffizienten a, b, c und d.

In einer anderen Ausführungsform des Verfahrens wird der Funktionswert f = f(S1, S2) = S1-S2 als Differenz aus den beiden unnormierten Signalen S1 und S2 gebildet. Es wird wieder das erste Signal S1 als Meßsignal herangezogen und normiert. Diese Normierung kann wieder durch Bildung des Quotienten aus seinem Wechselsignalanteil und seinem Gleichsignalanteil erfolgen. Das normierte Signal P1 kann aber auch aus dem Quotienten S1/(S1+S2) oder dem Quotienten (S1-S2)/(S1+S2) der beiden Signale S1 und S2 hergeleitet werden. Aus dem normierten Signal P1 und dem Funktionswert f wird dann das temperaturkorrigierte Meßsignal SA abgeleitet. Diese Ausführungsform des Verfahrens ist besonders vorteilhaft in Verbindung mit einer Vorrichtung, bei der die Übertragungsstrecken, insbesondere die Lichtwellenleiter, für die Lichtsignale LS1 und LS2, kurz sind und in denen somit keine allzu große Dämpfung auftritt.

Das temperaturkorrigierte Meßsignal SA ist ein direktes Maß für den vom Wechselstrom $I_A$ abhängigen Meßwinkel ALPHA. Zum Ermitteln aes Meßsignals SA werden entweder das unnormierte Signal S1 oder das normierte Signal P1 einerseits und der Funktionswert f als Maß für die Temperatur T andererseits herangezogen. Das Meßsignal SA wird aus dem Signal S1 bzw. P1 durch Korrektur mit dem Funktionswert f selbst oder dem daraus ermittelten Temperaturmeßwert T vorzugsweise anhand einer theoretisch angenäherten oder experimentell ermittelten Eichkurve oder Wertetabelle abgeleitet.

**Patentansprüche**

1. Verfahren zum Messen eines elektrischen Wechselstromes ($I_A$) in einem Stromleiter (2), bei dem

   a) dem Stromleiter (2) ein Faraday-Element (3) zugeordnet wird,
   b) in dieses Faraday-Element (3) linear polarisiertes Licht eingekoppelt wird und die Polarisationsebene dieses linear polarisierten Lichts aufgrund des Faraday-Effekts um einen Meßwinkel (ALPHA) gedreht wird, wobei dieser Meßwinkel (ALPHA) ein Maß für den elektrischen Wechselstrom ($I_A$) in dem Stromleiter (2) ist,

c) das Licht mit der um den Meßwinkel (ALPHA) gedrehten Polarisationsebene aus dem Faraday-Element (3) ausgekoppelt wird und in zwei Lichtsignale (LS1 und LS2) mit unterschiedlichen Polarisationsebenen aufgeteilt wird,

d) beide Lichtsignale (LS1 und LS2) jeweils in ein elektrisches Signal (S1, S2) umgewandelt werden, das ein Maß für die Intensität des entsprechenden Lichtsignals (LS1 bzw. LS2) ist,

**dadurch gekennzeichnet,** daß

e) aus den beiden elektrischen Signalen (S1 und S2) ein Funktionswert (f) gebildet wird, der ein eindeutiges Maß für die Temperatur (T) ist, und

f) mit diesem Funktionswert (f) und einem ersten der beiden elektrischen Signale (S1) ein weitgehend temperaturunabhängiges Meßsignal (SA) für den Wechselstrom ($I_A$) ermittelt wird.

2. Verfahren nach Anspruch 1, bei dem wenigstens das erste elektrische Signal (S1) in ein intensitätsnormiertes Signal (P1) umgewandelt wird und dieses intensitätsnormierte Signal (P1) zum Ermitteln des Meßsignals (SA) herangezogen wird.

3. Verfahren nach Anspruch 2, bei dem

a) auch das zweite elektrische Signal (S2) in ein intensitätsnormiertes Signal (P2) umgewandelt wird und

b) der Funktionswert (f) aus den beiden intensitätsnormierten Signalen (P1 und P2) gebildet wird.

4. Verfahren nach Anspruch 2 oder Anspruch 3, bei dem zur Intensitätsnormierung jedes zu normierende Signal (S1 und/oder S2) in seinen entsprechenden Gleichsignalanteil (D1 bzw. D2) und seinen entsprechenden Wechselsignalanteil (A1 bzw. A2) zerlegt wird und der Quotient aus seinem Wechselsignalanteil (A1 bzw. A2) und seinem Gleichsignalanteil (D1 bzw. D2) als intensitätsnormiertes Signal (P1 bzw. P2) ermittelt wird.

5. Verfahren nach Anspruch 2 oder 3, bei dem das intensitätsnormierte Signal (P1) aus dem ersten Signal (S1) durch Bildung des Quotienten (S1/(S1+S2)) aus dem ersten Signal (S1) und der Summe (S1+S2) der beiden Signale (S1 und S2) hergeleitet wird.

6. Verfahren nach Anspruch 2 oder 3, bei dem das intensitätsnormierte Signal (P1) aus dem ersten Signal (S1) durch Bildung des Quotienten ((S1-S2)/(S1+S2)) aus der Differenz (S1-S2) und der Summe (S1+S2) der beiden Signale (S1 und S2) hergeleitet wird.

7. Verfahren nach einem der vorhergehenden Ansprüche, bei dem als Funktionswert (f) eine Differenz (S1-S2 bzw. P1-P2) der beiden Signale (S1 bzw. P1 und S2 bzw. P2) vorgesehen wird.

8. Verfahren nach Anspruch 4, bei dem als Funktionswert (f) ein Quotient (P1/P2) der beiden intensitätsnormierten Signale (P1 und P2) vorgesehen wird.

9. Verfahren nach einem der vorhergehenden Ansprüche, bei dem das Meßsignal (SA) mit Hilfe einer vorab ermittelten Eichkurve oder Wertetabelle ermittelt wird.

10. Vorrichtung zum Messen eines elektrischen Wechselstromes ($I_A$) in einem Stromleiter (2) mit

a) einem dem Stromleiter (2) zugeordneten Faraday-Element (3),

b) Mitteln (4, 5) zum Einkoppeln von linear polarisiertem Licht in das Faraday-Element (3),

c) einem mit dem Faraday-Element (3) optisch gekoppelten, strahlteilenden Analysator (8) zum Aufteilen des aus dem Faraday-Element (3) ausgekoppelten Lichts mit aufgrund des Faraday-Effekts in dem Faraday-Element (3) in Abhängigkeit vom Wechselstrom ($I_A$) gedrehter Polarisationsebene in zwei Lichtsignale (LS1, LS2) mit unterschiedlichen Polarisationsebenen,

d) für jedes der beiden Lichtsignale (LS1, LS2) jeweils einem optoelektrischen Wandler (12, 22) zum Umwandeln des jeweiligen Lichtsignals (LS1, LS2) in ein elektrisches Signal (S1, S2), das ein Maß für die Intensität des entsprechenden Lichtsignals (LS1, LS2) ist,

**dadurch gekennzeichnet,** daß

e) eine mit den beiden Wandlern (12, 22) elektrisch verbundene Recheneinheit (30) vorgesehen ist zum Bilden eines Funktionswertes (f) aus den beiden elektrischen Signalen (S1, S2), der ein eindeutiges Maß für die Temperatur (T) ist,

f) eine Auswerteeinheit (40) zum Ableiten eines weitgehend temperaturunabhängigen Meßsignals (SA) für den Wechselstrom ($I_A$) aus dem Funktionswert (f) und einem ersten der beiden elektrischen Signale (S1) vorgesehen ist, die mit dem das erste elektrische Signal (S1) erzeugenden Wandler (12) und der Recheneinheit (30) elektrisch verbunden ist.

11. Vorrichtung nach Anspruch 10, bei der das Faraday-Element (3) und der Analysator (8) über einen polarisationserhaltenden Lichtwellenleiter (6) optisch miteinander verbunden sind.

12. Vorrichtung nach Anspruch 10 oder Anspruch 11, bei der für jedes der beiden Lichtsignale (LS1 und LS2) ein Lichtwellenleiter vorgesehen ist, der den Analysator (8) und den jeweiligen optoelektrischen Wandler (12 bzw. 22) optisch verbindet.

13. Vorrichtung nach einem der Ansprüche 10 bis 12, bei der die Auswerteeinheit (40) einen zusätzlichen Ausgang für einen aus dem Funktionswert (f) ermittelten Temperaturmeßwert (T) aufweist.

**Claims**

1. A process for measuring an electric alternating current ($I_A$) in a current conductor (2) wherein

    a) the current conductor (2) is assigned a Faraday element (3)
    b) linearly polarised light is input-coupled into this Faraday element (3) and the polarisation plane of this linearly polarised light is rotated by a measurement angle (ALPHA) as a result of the Faraday effect, where this measurement angle (ALPHA) is a gauge of the electric alternating current ($I_A$) in the current conductor (2)
    c) the light with the polarisation plane rotated by the measurement angle (ALPHA) is output-coupled from the Faraday element (3) and split into two light signals (LS1 and LS2) with different polarisation planes
    d) the two light signals (LS1 and LS2) are in each case converted into an electric signal (S1, S2) which is a gauge of the intensity of the corresponding light signal (LS1 and LS2),

    characterised in that

    e) from the two electric signals (S1 and S2) a function value (f) is formed which is a clear gauge of the temperature (T) and
    f) with this function value (f) and a first of the two electrical signals (S1) a substantially temperature-independent measurement signal (SA) for the alternating current ($I_A$) is calculated.

2. A process according to Claim 1, wherein at least the first electrical signal (S1) is converted into an intensity-standardized signal (P1) and this intensity-standardized signal (P1) is used to calculate the measurement signal (SA).

3. A process according to Claim 2 wherein

    a) the second electrical signal (S2) is also converted into an intensity-standardized signal (P2) and
    b) the function value (f) is formed from the two intensity-standardized signals (P1 and P2).

4. A process according to Claim 2 or Claim 3 wherein, for the intensity standardization, each signal to be standardized (S1 and/or S2) is split into its corresponding d.c. signal component (D1 and D2) and its corresponding a.c. signal component (A1 and A2) and the quotient of its a.c. signal component (A1 and A2) and its d.c. signal component (D1 and D2) is calculated as intensity-standardized signal (P1 and P2).

5. A process according to Claim 2 or 3, wherein the intensity-standardized signal (P1) is derived from the first signal (S1) by forming the quotient (S1/(S1+S2)) of the first signal (S1) and the sum (S1+S2) of the two signals (S1 and S2).

6. A process according to Claim 2 or 3, wherein the intensity-standardized signal (P1) is derived from the first signal (S1) by forming the quotient ((S1-S2)/(S1+S2)) of the difference (S1-S2) and the sum (S1+S2) of the two signals (S1 and S2).

7. A process according to one of the preceding claims, wherein a difference (S1-S2 and P1-P2) of the two signals (S1 and P1 ; S2 and P2) is provided as function value (f).

8. A process according to Claim 4 wherein a quotient (P1/P2) of the two intensity-standardized signals (P1 and P2) is provided as function value (f).

9. A process according to one of the preceding claims wherein the measurement signal (SA) is calculated with the aid of a previously calculated calibration curve or table of values.

10. A device for measuring an electric alternating current ($I_A$) in a current conductor (2) with

    a) a Faraday element (3) assigned to the current conductor (2)
    b) means (4, 5) for the input-coupling of linearly polarised light into the Faraday element (3),
    c) a beam-dividing analyzer (8), optically coupled to the Faraday element (3), for splitting the light which has a polarisation plane rotated in dependence upon the alternating current ($I_A$)

as a result of the Faraday effect in the Faraday element (3) and has been output-coupled from the Faraday element (3) into two light signals (LS1, LS2) with different polarisation planes,

d) for each of the two light signals (LS1, LS2), a respective opto-electric transducer (12, 22) for converting the respective light signal (LS1, LS2) into an electrical signal (S1, S2) which is a gauge of the intensity of the corresponding light signal (LS1, LS2),

characterised in that

e) a computing unit (30) electrically connected to the two transducers (12, 22) is provided for forming, from the two electrical signals (S1, S2), a function value (f) which is a clear gauge of the temperature (T),

f) an evaluating unit (40) for obtaining a substantially temperature-independent measurement signal (SA) for the alternating current ($I_A$) from the function value (f) and from a first of the two electrical signals (S1) is provided, which evaluating unit (40) is electrically connected to the transducer (12) which generates the first electrical signal (L2) and to the computing unit (30).

11. A device according to Claim 10 wherein the Faraday element (3) and the analyzer (8) are optically connected to one another via a polarisation-maintaining optical waveguide (6).

12. A device according to Claim 10 or Claim 11 wherein, for each of the two light signals (LS1 and LS2), an optical waveguide is provided which optically connects the analyzer (8) and the respective opto-electric transducer (12 and 22).

13. A device according to one of Claims 10 to 12 wherein the evaluating unit (40) has an additional output for a temperature measurement value (T) calculated from the function value (f).

**Revendications**

1. Procédé de mesure d'un courant ($I_A$) électrique alternatif dans un conducteur (2) de courant, dans lequel

a) on associe un élément (3) produisant l'effet Faraday au conducteur (2) de courant,

b) on envoie dans cet élément (3) produisant l'effet Faraday de la lumière à polarisation linéaire, et, en raison de l'effet Faraday, le plan de polarisation de cette lumière à polarisation linéaire tourne d'un angle (ALPHA) de mesure, cet angle (ALPHA) de mesure étant une mesure du courant ($I_A$) électrique alternatif dans le conducteur (2) de courant,

c) on fait sortir de l'élément (3) produisant l'effet Faraday la lumière ayant le plan de polarisation tourné de l'angle (ALPHA) de mesure et on la sépare en deux signaux (LS1 et LS2) lumineux ayant des plans de polarisation différents,

d) on convertit les deux signaux (LS1 et LS2) lumineux chacun en un signal (S1, S2) électrique, qui est une mesure de l'intensité du signal (LS1, respectivement LS2) lumineux associé,

caractérisé en ce que

e) on forme à partir des deux signaux (S1 et S2) électriques une valeur (f) de fonction, qui est une mesure univoque de la température (T), et

f) on détermine par cette valeur (f) de fonction et par un premier (S1) des deux signaux électriques, un signal (SA) de mesure du courant ($I_A$) électrique alternatif, qui dépend dans une grande mesure de la température.

2. Procédé suivant la revendication 1, dans lequel on convertit au moins le premier signal (S1) électrique en un signal (P1) normé en intensité et on utilise ce signal (P1) normé en intensité pour déterminer le signal (SA) de mesure.

3. Procédé suivant la revendication 2, dans lequel

a) on convertit aussi le deuxième signal (S2) électrique en un signal (P2) normé en intensité et

b) on forme la valeur (f) de fonction à partie des deux signaux (P1 et P2) normés en intensité.

4. Procédé suivant la revendication 2 ou la revendication 3, dans lequel, pour normer en intensité chaque signal (S1 et/ou S2) à normer, on le décompose en sa composante (D1 et D2) de signal continue correspondante et en sa composante (A1 et A2) de signal alternative correspondante et on calcule comme signal (P1 et/ou P2) normé en intensité le quotient de sa composante (A1 et A2) de signal alternative sur sa composante (D1 et D2) de signal continue.

5. Procédé suivant la revendication 2 ou 3, dans lequel on déduit le signal (P1) normé en intensité à partir du premier signal (S1), en formant le quotient (S1/(S1+S2)) du premier signal (S1) sur la somme des deux signaux (S1 et S2).

6. Procédé suivant la revendication 2 ou 3, dans lequel on déduit le signal (P1) normé en intensité à partir du premier signal (S1), en formant le quotient ((S1-S2)/(S1+S2)) de la différence (S1-S2) des deux signaux (S1 et S2) sur leur somme (S1+S2).

7. Procédé suivant l'une des revendications précédentes, dans lequel on prévoit comme valeur (f) de fonction une différence (S1-S2 ou P1-P2) des deux signaux (S1 ou P1 et S2 ou P2).

8. Procédé suivant la revendication 4, dans lequel on prévoit comme valeur (f) de fonction un quotient (P1/P2) des deux signaux (P1 et P2) normés en intensité.

9. Procédé suivant l'une des revendications précédentes, dans lequel on détermine le signal (SA) de mesure à l'aide d'une courbe d'étalonnage ou d'une table des valeurs déterminée antérieurement.

10. Dispositif de mesure d'un courant ($I_A$) électrique alternatif dans un conducteur (2) de courant, comportant

   a) un élément (3) produisant l'effet Faraday associé au conducteur (2) de courant,
   b) des moyens (4, 5) pour envoyer de la lumière à polarisation linéaire dans l'élément (3) produisant l'effet Faraday,
   c) un analyseur (8) séparateur de faisceau, couplé du point de vue optique à l'élément (3) produisant l'effet Faraday, servant à séparer en deux signaux (LS1, LS2) lumineux ayant des plans de polarisation différents la lumière sortant de l'élément (3) produisant l'effet Faraday et ayant, en raison de l'effet Faraday dans l'élément (3) produisant l'effet Faraday, une rotation du plan de polarisation en fonction du courant ($I_A$) électrique alternatif,
   d) pour chacun des deux signaux (LS1, LS2) lumineux un transducteur (12, 22) opto-électrique pour convertir le signal (LS1, LS2) lumineux associé en un signal (S1, S2) électrique, qui est une mesure de l'intensité du signal (LS1, LS2) lumineux associé,

caractérisé en ce que

   e), pour, à partir des deux signaux (S1, S2) électriques, former une valeur (f) de fonction, qui est une mesure univoque de la température (T), il est prévu une unité (30) de calcul reliée du point de vue électrique aux deux transducteurs (12, 22),
   f) il est prévu une unité (40) d'exploitation pour déduire de la valeur (f) de fonction et d'un premier (S1) des deux signaux électriques un signal (SA) de mesure, qui dans une grande mesure ne dépend pas de la température, du courant ($I_A$) électrique alternatif, l'unité (40) d'exploitation étant reliée du point de vue électrique au transducteur (12) qui produit le premier signal (S1) électrique et à l'unité (30) de calcul.

11. Dispositif suivant la revendication 10, dans lequel l'élément (3) produisant l'effet Faraday et l'analyseur (8) sont reliés l'une à l'autre du point de vue optique par l'intermédiaire d'un guide (6) d'ondes lumineuses conservant la polarisation.

12. Dispositif suivant la revendication 10 ou la revendication 11, dans lequel il est prévu, pour chacun des deux signaux (LS1, LS2) lumineux, un guide d'ondes lumineuses qui relie du point de vue optique l'analyseur (8) et le transducteur (12 et 22) opto-électrique associé.

13. Dispositif suivant l'une des revendications 10 à 12, dans lequel l'unité (40) d'exploitation comporte une sortie supplémentaire pour une valeur (T) de mesure de la température déterminée à partir de la valeur (f) de fonction.